## Europäisches Patentamt
## European Patent Office
## Office européen des brevets

(19)

(11) Numéro de publication: **0 256 073**
**B1**

(12)

# FASCICULE DE BREVET EUROPEEN

(45) Date de publication du fascicule du brevet: **12.09.90**

(51) Int. Cl.⁵: **C 23 C 16/00, C 04 B 41/87**

(21) Numéro de dépôt: **87901063.5**

(22) Date de dépôt: **09.02.87**

(86) Numéro de dépót international:
**PCT/FR87/00036**

(87) Numéro de publication internationale:
**WO 87/04733 13.08.87 Gazette 87/18**

(54) **INSTALLATION POUR L'INFILTRATION CHIMIQUE EN PHASE VAPEUR D'UN MATERIAU REFRACTAIRE AUTRE QUE LE CARBONE.**

(30) Priorité: **10.02.86 FR 8601790**

(43) Date de publication de la demande:
**24.02.88 Bulletin 88/08**

(45) Mention de la délivrance du brevet:
**12.09.90 Bulletin 90/37**

(84) Etats contractants désignés:
**BE CH DE FR GB IT LI NL SE**

(56) Documents cités:
**FR-A-2 207 883**
**FR-A-2 401 888**

**Ceramic Engineering and Science Proceedings, vol. 6, no. 7/8, juillet-aou7t 1985, Columbus, Ohio, US; A.J. Caputo et al.:"Development of a new, faster process for the fabricationh of ceramic fiber-reinforced ceramic composites by chemical vapor infiltration", pages 694-706**

(73) Titulaire: **SOCIETE EUROPEENNE DE PROPULSION**
**24 rue Salomon de Rothschild**
**F-92150 Suresnes (FR)**

(72) Inventeur: **CHRISTIN, François**
**Chemin de la Tuilerie**
**F-33160 Saint Aubin de Médoc (FR)**

(74) Mandataire: **Joly, Jean-Jacques et al**
**CABINET BEAU DE LOMENIE 55, rue d'Amsterdam**
**F-75008 Paris (FR)**

Courier Press, Leamington Spa, England.

## Description

La présente invention concerne une installation pour la densification de pièces poreuses par infiltration chimique en phase vapeur d'un matériau réfractaire autre que le carbone.

Le domaine d'application de l'invention est donc la fabrication de pièces composites à matrice réfractaire en un matériau différent du carbone, notamment en carbure de silicium ou en alumine.

On connaît déjà des installations industrielles destinées à la densification de pièces poreuses carbonées par dépôt chimique en phase vapeur de carbone pour réaliser des pièces composites en carbone/carbone.

Mais ces installations s'avèrent inadaptées à l'infiltration de matériaux tels que le carbure de silicium ou l'alumine. Une raison tient à ce que l'infiltration de tels matériaux demande l'utilisation de gaz réactifs ou implique la production de produits de réaction tel l'acide chlorhydrique qui constituent des espèces chimiques délicates à manipuler. Une autre raison réside dans la difficulté de réaliser des infiltrations uniformes et exemptes de dépôts parasites.

C'est pourquoi la présente invention a pour but de fournir une installation permettant la densification de pièces poreuses par un matériau réfractaire, tel que le carbure de silicium ou l'alumine, dans des conditions de sécurité et avec la fiabilité qui sont requises au stade industriel.

Ce but est atteint grâce à une installation du type comprenant un induit en graphite délimitant une chambre de réaction, un inducteur entourant l'induit pour chauffer la chambre de réaction par induction, une enceinte étanche contenant l'induit et l'inducteur, des moyens d'alimentation de la chambre de réaction en gaz réactifs, des moyens d'alimentation de l'enceinte en gaz inerte et des moyens d'extraction de gaz hors de la chambre de réaction et de l'enceinte, installation dans laquelle, conformément à l'invention, l'induit constitue une structure étanche à l'intérieur de l'enceinte et est raccordé à l'extérieur de l'enceinte aux moyens d'alimentation en gaz réactifs, l'enceinte est alimentée en gaz inerte pour maintenir en permanence une circulation de gaz inerte dans l'espace entourant l'induit à l'intérieur de l'enceinte, et l'évacuation de gaz hors de la chambre de réaction et du gaz inerte hors de l'enceinte est réalisée au moyen de canalisations d'évacuation respectives qui se rejoignent à l'extérieur de l'enceinte, de sorte que des pressions sensiblement égales sont maintenues dans l'enceinte à l'intérieur et à l'extérieur de la chambre de réaction.

La structure étanche de l'induit empéche les gaz réactifs et les produits de réaction de venir au contact de pièces du four d'infiltration à l'extérieur de l'induit, notamment l'inducteur métallique, pièces à l'égard desquelles ces gaz présenteraient une agressivité particulière. Le balayage de l'enceinte à l'extérieur de l'induit par un gaz neutre assure une protection en formant un tampon autour de la chambre de réaction. De plus, le maintien à des valeurs égales des pressions dans l'enceinte à l'intérieur et à l'extérieur de l'enduit évite une fuite de gaz neutre dans la chambre de réaction, ce qui perturberait le processus d'infiltration, ou une fuite de gaz réactifs ou de produits de réaction agressifs ou dangereux dans l'enceinte à l'extérieur de la chambre de réaction.

De préférence, les moyens d'extraction de gaz comportent un dispositif de pompage à anneau liquide, comme une pompe à anneau d'eau, auquel sont raccordées les canalisations d'évacuation. Avec un tel dispositif de pompage, l'extraction de produits corrosifs, tel l'acide chlorhydrique, est rendue possible sans les systèmes de protection coûteux qui seraient nécessaires avec d'autres dispositifs de pompage, comme les pompes à palettes.

D'autres particularités et avantages de l'installation conforme à l'invention ressortiront à la lecture de la description faite ci-après à titre indicatif mais non limitatif en référence aux dessins annexés sur lesquels:
- la figure 1 est une vue très schématique d'une installation connue pour l'infiltration chimique en phase vapeur de carbone;
- la figure 2 est une vue schématique d'un mode de réalisation d'une installation selon l'invention pour l'infiltration en phase vapeur de carbure de silicium; et
- la figure 3 est une vue partielle montrant de façon plus détaillée le dispositif d'extraction de l'installation de la figure 2.

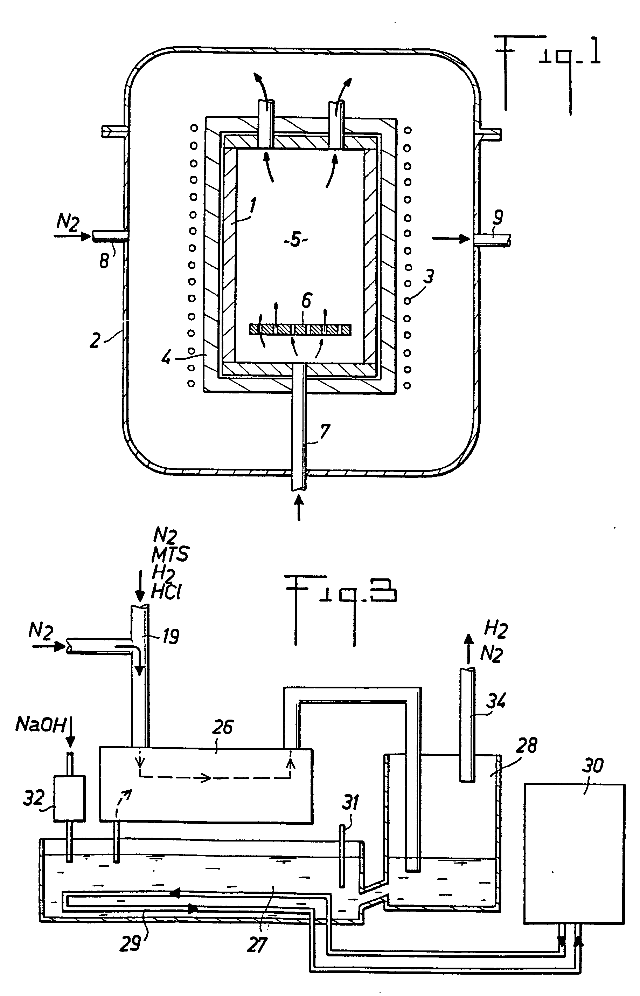

Sur la figure 1 est représenté très schématiquement un four de l'art antérieur pour l'infiltration en phase vapeur de carbone. Un induit en graphite 1 est logé à l'intérieur d'une enceinte métallique étanche 2. Un inducteur métallique 3 disposé également à l'intérieur de l'enceinte 2 entoure l'induit 1 avec interposition d'un isolant thermique 4. L'induit 1 délimite une chambre de réaction 5 dans laquelle des pièces poreuses à densifier sont disposées sur un support 6. La chambre 5 est alimentée en gaz réactifs par une canalisation 7 qui s'ouvre au fond de la chambre et l'enceinte 2 est alimentée en gaz neutre (azote) par une canalisation 8. Les produits de réaction et les gaz réactifs non utilisés sont évacués hors de la chambre de réaction 5 par des ouvertures formées au sommet de celle-ci puis sont évacuées hors de l'enceinte, avec le gaz neutre, par une canalisation d'évacuation 9 qui s'ouvre dans l'enceinte 2 à l'opposé de la canalisation 8.

Le dépôt chimique en phase vapeur du carbone au sein de la porosité des pièces à densifier est obtenu par craquage d'alcanes, notamment du méthane ou des mélanges de méthane et d'alcanes plus lourds. Dans des conditions de température et de pression adaptées, ces gaz réactifs donnent naissance à du carbone et à de l'hydrogène. L'extraction de l'hydrogène, des alcanes non décomposés et de l'azote est réalisée par pompage afin de maintenir la pression voulue dans la chambre de réaction, la manipulation de ces gaz ne posant pas de problème particulier au stade industriel.

Par contre, l'infiltration chimique en phase vapeur de matériaux réfractaires autres que le carbone soulève des difficultés.

Ainsi, l'infiltration de carbure de silicium est réalisée par décomposition d'un produit chimique plus complexe que les alcanes, à savoir, par exemple le méthyltrichlorosilane $CH_3SiCl_3$ (ci-après MTS) qui donne naissance en présence d'hydrogène $H_2$ servant de catalyseur et dans des conditions de température et de pression adaptées, à du carbure de silicium SiC et de l'acide chlorhydrique HCl. Le MTS, qui est liquide dans les conditions normales de température et de pression, est d'une manipulation délicate en raison de son agressivité; il en est de même bien évidemment de l'acide chlorhydrique. L'infiltration de carbure de silicium pose encore d'autres problèmes particuliers tels qu'une mauvaise uniformité du dépôt et l'existence de dépôts parasites de silicium et de carbone.

Ces problèmes se rencontrent également dans le cas d'infiltration d'autres matériaux différents du carbone, comme par exemple l'alumine. D'une façon générale, en ce qui concerne les conditions opératoires à respecter pour l'infiltration chimique en phase vapeur de matériaux réfractaires autres que le carbone, on pourra se référer au brevet français No. 2 401 888.

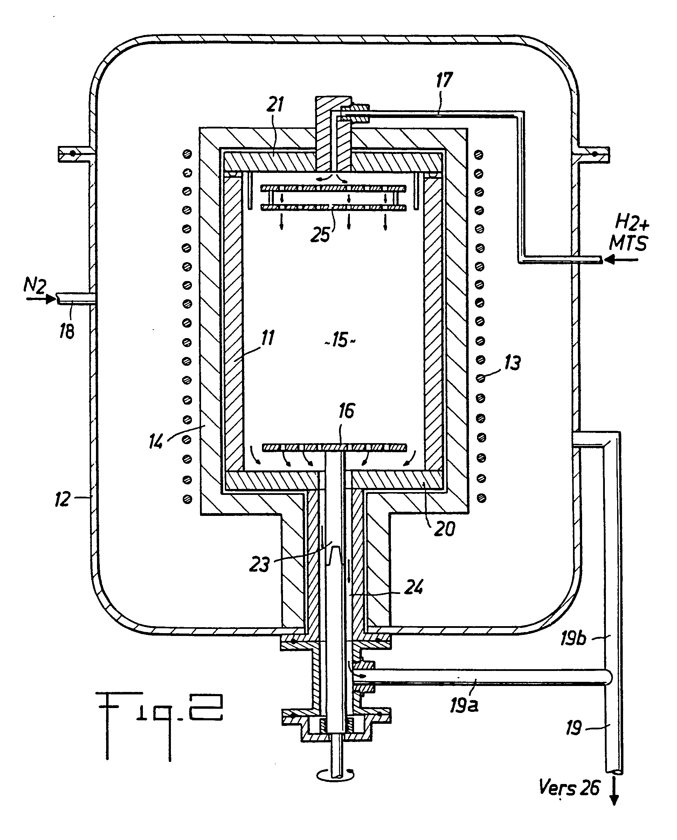

Les problèmes précités peuvent être résolus en utilisant une installation d'infiltration conforme à l'invention dont un mode de réalisation est illustré par la figure 2.

Cette installation comprend de façon classique un induit en graphite 11 logé à l'intérieur d'une enceinte métallique étanche 12 et délimitant une chambre de réaction 15. A l'intérieur de l'enceinte 12, l'induit 11 est entouré d'un inducteur métallique 13 avec interposition d'un isolant thermique 14.

Conformément à une caractéristique de l'invention l'induit 11 constitue une structure étanche. Il est sous forme d'un cylindre d'axe vertical fermé à sa partie inférieure par un fond 20 solidaire de la paroi latérale et à sa partie supérieure par un couvercle amovible 21 qui s'appuie sur le rebord supérieur de la paroi latérale de l'induit.

A l'intérieur de la chambre 15, les pièces à densifier sont placées sur un plateau 16 pouvant tourner autour d'un axe vertical confondu avec celui de l'induit 11 et de l'inducteur 13. La rotation du plateau 16 est commandée au moyen d'un moteur (non représenté) couplé à un arbre 23 traversant la paroi inférieure de l'enceinte 12 et le fond 20 de l'induit et fixé au plateau 16 à la face inférieure de celui-ci.

L'alimentation de la chambre 15 en gaz réactifs, par exemple du MTS et de l'hydrogène $H_2$ servant de catalyseur pour le dépôt de carbure de silicium par décomposition du MTS, est réalisée par une canalisation 17 qui traverse la paroi de l'enceinte 12 et aboutit à la partie supérieure de la chambre, à travers le couvercle 21. L'extraction des gaz hors de la chambre 15 est réalisée au moyen d'une ou plusieurs canalisations 19a qui s'ouvrent à la partie inférieure de la chambre 15 et traversent le fond de l'induit 20 et la paroi inférieure de l'enceinte. Dans l'exemple illustré, les gaz sont évacués de la chambre 15 par un passage 24 à section annulaire entourant l'arbre 23 et raccordé à une canalisation 19a à l'extérieur de l'enceinte 12.

Les gaz réactifs entrant dans la chambre 15 parviennent tout d'abord au contact de plateaux de préchauffage 25. Ceux-ci se présentent par exemple sous forme de plaques perforées superposées. Les plateaux de préchauffage étant situés à l'intérieur de la chambre de réaction, ils sont en permanence à la température régnant dans celle-ci, température déterminée de manière à permettre une infiltration optimale. Les gaz réactifs passant à travers les plateaux de préchauffage 25 sont donc portés par ceux-ci à la température voulue avant de venir au contact des pièces à densifier. Les plateaux de préchauffage 25 ont également pour fonction de piéger les dépôts parasites, l'expérience ayant montré que ceux-ci ont tendance à se former sur les premières surfaces rencontrées par les gaz réactifs lorsqu'ils ont atteint la température de décomposition. En raison de leur emplacement à la partie supérieure de la chambre de réaction, les plateaux de préchauffage 25 sont facilement accessibles après enlèvement du couvercle 21 pour permettre leur nettoyage périodique. Bien que l'on ait ci-avant envisagé l'utilisation de plaques perforées, le dispositif de préchauffage pourra bien entendu prendre toute autre forme apte à assurer un préchauffage des gaz réactifs et un piégeage des dépôts parasites par contact avec les gaz réactifs dès leur entrée dans la chambre de réaction.

Le volume situé autour de l'induit 11 à l'intérieur de l'enceinte 12 est balayé en permanence par un gaz neutre, tel que de l'azote $N_2$, amené par une canalisation 18 et extrait par une canalisation 19b. On forme ainsi un tampon de gaz neutre autour de la chambre de réaction. Lorsque des gaz présentant certains dangers sont introduits dans la chambre de réaction, comme par exemple l'hydrogène $H_2$ en raison de son caractère explosif, le tampon de gaz neutre assure une protection contre les fuites éventuelles hors de la chambre de réaction.

A l'extérieur de l'enceinte, les canalisations 19a et 19b se rejoignent pour former une canalisation d'évacuation unique 19 qui est raccordée à un dispositif de pompage 26. Ce dernier permet de maintenir dans la chambre de réaction 15 la pression à la faible valeur nécessaire à l'infiltration. Les pressions régnant dans l'enceinte 12 à l'intérieur et à l'extérieur de l'induit 11 sont maintenues à des valeurs égales du fait de la liaison entre les canalisations 19a et 19b. On évite ainsi l'établissement d'une pression différentielle qui pourrait favoriser une fuite de gaz neutre à l'intérieur de la chambre de réaction ou une fuite de gaz réactifs à l'extérieur de celle-ci.

Le dispositif de pompage 26 est du type à anneau liquide. La présence d'espèces chimiques difficiles à manipuler comme le MTS non décomposé et l'acide chlorhydrique parmi les gaz extraits du four d'infiltration n'autorise pas l'utilisation de pompes à palettes sans précautions particulières telle que l'utilisation de pièges à azote liquide pour transformer le MTS et l'acide chlorhydrique en solides. Mais une telle solution présenterait sur le plan industriel divers inconvénients: nettoyages fréquents des pièges à azote liquide, surveillance du niveau d'azote liquide, corrosion de la pompe, prix de revient élevé. Ces inconvénients sont évités grâce à l'emploi d'un dispositif de pompage à anneau liquide.

Les pompes à anneaux liquides sont connues en elles-mêmes. Elles consistent à mettre en mouvement un liquide qui, par cavitation, crée une dépression. De préférence, le dispositif de pompage 26 est à anneau d'eau et comprend une ou plusieurs pompes en série. La ou les pompes peuvent fonctionner dans une configuration à eau perdue (circuit d'eau ouvert) ou à eau recyclée (circuit d'eau fermé).

Dans ce dernier cas, lorsque de l'acide chlorhydrique est présent dans les gaz pompés, il convient de surveiller l'acidité de l'eau de service. Ceci peut être réalisé en injectant une base, par exemple de la soude pour neutraliser en continu l'acide chlorhydrique présent dans le circuit d'eau.

La figure 3 montre un dispositif de pompage à anneau d'eau avec une configuration à eau recyclée. La pompe à anneau d'eau 26 reçoit, d'une part, les gaz extraits du four d'infiltration (MTS, acide chlorhydrique, hydrogène et azote) et, d'autre part, l'eau de service aspirée d'un bac de recyclage 27. L'eau et les gaz en sortie de la pompe 26 sont amenés à un bac de décantation 28. Les gaz restants (essentiellement l'hydrogène et l'azote) sont évacués du bac 28 par une conduite 34 tandis que l'eau est ramenée du bac de décantation au bac de recyclage 27. Pour éviter un échauffement progressif de l'eau de service par le contact avec les gaz provenant du four d'infiltration, et par l'énergie dissipée par la pompe, un serpentin de refroidissement 29 est disposé dans le bac et est parcouru par un fluide de refroidissement qui circule en circuit fermé entre le serpentin 29 et un groupe frigorifique 30.

Le contrôle de l'acidité de l'eau est réalisé au moyen d'une sonde 31 de mesure de pH qui fournit un signal représentatif du pH de l'eau à l'intérieur du bac de recyclage. Un circuit de régulation (non représenté) reçoit le signal de la sonde 31 pour commander l'injection de soude dans le bac 27 au moyen d'une pompe 32 lorsque le pH descend en-dessous d'un seuil déterminé.

On notera par ailleurs que le MTS non décomposé présent dans les gaz extraits conduit, par réaction avec l'eau, à la formation de silice. Le dépôt de celle-ci dans les canalisations, avec un risque d'obstruction à plus ou moins long terme, est évité grâce au balayage des canalisations par de l'azote $N_2$ amené dans la canalisation 19 immédiatement en amont de la pompe 26.

Le fonctionnement de l'installation décrite ci-avant découle à l'évidence de ce qui précède. Les gaz réactifs préchauffés à la température voulue grâce aux plateaux de préchauffage 25 viennent au contact des pièces à densifier disposées sur le plateau tournant 16 pour former le dépôt voulu au sein de la porosité de ces pièces. L'écoulement des gaz réactifs n'étant pas uniforme dans toute la section de la chambre de réaction, la rotation du plateau 16 permet malgré tout l'obtention de dépôts uniformes au sein des pièces à densifier.

Comme déjà indiqué, l'installation selon l'invention trouve une application particulièrement intéressante pour la réalisation industrielle de pièces composites à matrice en carbure de silicium. Mais l'installation selon l'invention est également utilisable pour la réalisation de pièces composites à matrice en un matériau différent du carbone autre que le carbure de silicium, par exemple en alumine, l'infiltration chimique en phase vapeur de l'alumine étant réalisée par réaction de chlorure d'aluminium avec du dioxyde de carbone et de l'hydrogène donnant notamment de l'alumine et de l'acide chlorhydrique dans des conditions particulières de température et de pression.

**Revendications**

1. Installation pour la densification de pièces poreuses par infiltration chimique en phase vapeur d'un matériau réfractaire autre que le carbone, installation comportant un induit en graphite (11) délimitant une chambre de réaction (15), un inducteur (13) entourant l'induit pour chauffer la chambre de réaction par induction, une enceinte étanche (12) contenant l'induit et l'inducteur, des moyens d'alimentation de la chambre de réaction en gaz réactifs, des moyens d'alimentation de l'enceinte en gaz inerte et des moyens (19a, 19b, 19, 26) d'extraction de gaz hors de la chambre de réaction et de l'enceinte, caractérisée en ce que l'induit (11) constitue une structure étanche à l'intérieur de l'enceinte (12) et est raccordé à l'extérieur de l'enceinte aux moyens d'alimentation en gaz réactifs, l'enceinte (12) est alimentée en gaz inerte pour maintenir en permanence une circulation de gaz inerte dans l'espace entourant l'induit à l'intérieur de l'enceinte, et l'évacuation de produits de réaction hors de la chambre de réaction (15) et du gaz inerte hors de l'enceinte est réalisée au moyen de canalisations d'évacuation respectives (19a, 19b) qui se rejoignent à l'extérieur de l'enceinte, de sorte que des pressions sensiblement égales sont maintenues dans l'enceinte à l'intérieur et à l'extérieur de la chambre de réaction (15).

2. Installation selon la revendication 1, caractérisée en ce que les moyens d'extraction de gaz comportent un dispositif (26) de pompage à anneau liquide.

3. Installation selon la revendication 2, caractérisée en ce que le dispositif de pompage comprend au moins une pompe à anneau d'eau, un circuit fermé dans lequel circule l'eau de service de la pompe et des moyens de contrôle de l'acidité de l'eau.

4. Installation selon l'une quelconque des revendications 1 à 3, caractérisée en ce qu'elle comprend un dispositif de préchauffage (25) disposé à l'intérieur de la chambre de réaction (15) pour préchauffer les gaz réactifs sur leur trajet entre l'entrée dans la chambre de réaction (15) et les pièces à densifier.

5. Installation selon l'une quelconque des revendications 1 à 4, caractérisée en ce que l'induit (11) a une forme cylindrique d'axe vertical et est muni à sa partie supérieure d'un couvercle amovible (21).

6. Installation selon l'une quelconque des revendications 1 à 5, caractérisée en ce que les moyens d'alimentation en gaz réactifs de la chambre de réaction s'ouvrent dans la partie supérieure de celle-ci tandis que l'évacuation des gaz hors de la chambre de réaction est réalisée à la partie inférieure de celle-ci, l'écoulement des gaz dans la chambre de réaction étant réalisé du haut vers le bas.

**Patentansprüche**

1. Vorrichtung zur Verdichtung poröser Teile durch chemische Dampfphasen-Infiltration eines feuerfesten Materials außer dem Kohlenstoff, die einen Rotor (11) aus Graphit, der eine Reaktionskammer (15) begrenzt, einen Induktor (13), der den Rotor zwecks Erhitzung der Reaktionskammer durch Induktion umgibt, ein den Rotor und den Induktor enthaltendes dichtes Gehäuse (12), Mittel zur Speisung der Reaktionskammer mit reaktiven Gasen, Mittel zur Speisung des Gehäuses mit inertem Gas und Mittel (19a, 19b, 19, 26) zur Gasabführung aus der Reaktionskammer und dem Gehäuse aufweist, dadurch gekennzeichnet, daß der Rotor (11) einen dichten Aufbau im Inneren des Gehäuses darstellt und außerhalb des Gehäuses mit den Mitteln zur Speisung mit reaktiven Gasen verbunden ist, das Gehäuse (12) mit inertem Gas zur dauernden Aufrechterhaltung einer Zirkulation von inertem Gas in dem den Rotor im Inneren des Gehäuses umgebenden Raum gespeist wird und die Abführung von Reaktionsprodukten ·aus der Reaktionskammer (15) und des inerten Gases aus dem Gehäuse mittels entsprechender Abführleitungen (19a, 19b), die sich außerhalb des Gehäuses vereinigen, derart erfolgt, daß im Gehäuse innerhalb und außerhalb der Reaktionskammer (15) im wesentlichen gleiche Drücke aufrechterhalten werden.

2. Vorrichtung nach dem Anspruch 1, dadurch gekennzeichnet, daß die Gasabführungsmittel eine Einrichtung (26) zum Pumpen mit Flüssigkeitsring aufweisen.

3. Vorrichtung nach dem Anspruch 2, dadurch gekennzeichnet, daß die Pumpeinrichtung wenigstens eine Wasserringpumpe, einen geschlossenen Kreis, in dem das Wasser zum Betrieb der Pumpe zirkuliert, und Mittel zur Steuerung der Azidität des Wassers aufweist.

4. Vorrichtung nach irgendeinem der Ansprüche 1 bis 3, dadurch gekennzeichnet, daß sie eine Vorerhitzungseinrichtung (25) aufweist, die im Inneren der Reaktionskammer (15) zum Vorerhitzen der reaktiven Gase auf ihrem Weg zwischen dem Eintritt in die Reaktionskammer (15) und den zu verdichtenden Teilen angeordnet ist.

5. Vorrichtung nach irgendeinem der Ansprüche 1 bis 4, dadurch gekennzeichnet, daß der Rotor (11) eine zylindrische Form mit vertikaler Achse hat und an seinem oberen Teil mit einem abnehmbaren Deckel (21) ausgerüstet ist.

6. Vorrichtung nach irgendeinem der Ansprüche 1 bis 5, dadurch gekennzeichnet, daß die Mittel zur Speisung der Reaktionskammer mit reaktiven Gasen in deren oberem Teil münden, während die Abführung der Gase aus der Reaktionskammer an deren unterem Teil erfolgt, wobei die Strömung der Gase in der Reaktionskammer von oben nach unten verläuft.

**Claims**

1. Installation for the densification of porous pieces by chemical vapor infiltration of a refractory material other than carbon, installation comprising a graphite armature (11) defining a reaction chamber (15), an inductor (13) surrounding the armature and heating the reaction chamber by induction, a sealed enclosure (12) containing said armature and inductor, means for supplying reactant gases to the reaction chamber, means for supplying inert gas to the enclosure, and means (19a, 19b, 19, 26) for removing gases from said reaction chamber and said enclosure, characterized in that the armature (11) constitutes a tight structure inside the enclosure (12) and is connected outside said enclosure with the reactant gases supplying means, the enclosure (12) is supplied with inert gas in order to keep up a permanent flow of inert gas in the space around the armature inside the enclosure, and the removal of gases from the reaction chamber (15) and of inert gas from the enclosure is achieved via respective outlet conduits (19a, 19b) which join up outside the enclosure, so that substantially equal pressures are maintained in the enclosure, inside and outside the reaction chamber (15).

2. Installation according to claim 1, characterized in that the gas extracting means comprise a liquid ring pumping device (26).

3. Installation according to claim 2, characterized in that the pumping device comprises at least a water ring pump, a closed circuit in which flows the industrial water from the pump and means for controlling the acidity of the water.

4. Installation according to any one of claims 1 to 3, characterized in that a pre-heating device (25) is provided inside the reaction chamber (15) for pre-heating the reactant gases on their flowing path between the inlet into the reaction chamber (15) and the pieces to be densified.

5. Installation according to any one of claims 1 to 4, characterized in that the armature (11) has a cylindrical shape with vertical axis and is provided at its upper part with a removable lid (21).

6. Installation according to any one of claims 1 to 5, characterized in that the means for supplying reactant gases to the reaction chamber open into the upper part of said chamber whereas exhaust of the gases from the reaction chamber takes place at the bottom part of said chamber, the gases inside the reaction chamber flowing from the top towards the bottom.

Fig.1

Fig.3

Fig.2